Europäisches Patentamt

European Patent Office

Office européen des brevets

(11) Publication number: **0 189 296 B1**

## EUROPEAN PATENT SPECIFICATION

(45) Date of publication of patent specification: **01.04.92**  (51) Int. Cl.5: **H01S 3/19**

(21) Application number: **86300345.5**

(22) Date of filing: **20.01.86**

(54) **A semiconductor laser device.**

(30) Priority: **23.01.85 JP 11442/85**

(43) Date of publication of application:
**30.07.86 Bulletin 86/31**

(45) Publication of the grant of the patent:
**01.04.92 Bulletin 92/14**

(84) Designated Contracting States:
**DE GB NL**

(56) References cited:
**EP-A- 0 095 826**
**US-A- 4 282 494**

**APPLIED PHYSICS LETTERS, vol. 42, no. 5, March 1983, pages 406-408, American Institute of Physics, New York, US; S. YAMAMOTO et al.: "High optical power cw operation in visible spectral range by window V-channeled substrate inner stripe lasers"**

**PATENT ABSTRACTS OF JAPAN, vol. 8, no. 39 (E-228)[1476], 21st February 1984; & JP-A-58 197 787**

**PATENT ABSTRACTS OF JAPAN, vol. 5, no. 99 (E-63)[771], 26th June 1981; & JP-A-56 42**

393

(73) Proprietor: **SHARP KABUSHIKI KAISHA**
**22-22 Nagaike-cho Abeno-ku**
**Osaka 545(JP)**

(72) Inventor: **Maei, Shigeki**
**2613-1, Ichinomoto-cho**
**Tenri-shi Nara-ken(JP)**
Inventor: **Yamamoto, Saburo**
**1-2-11, Akanedai Haibara-cho**
**Uda-gun Nara-ken(JP)**
Inventor: **Hayashi, Hiroshi**
**5-8, 11-chome, Nagamodai**
**Kamo-cho Soraku-gun Kyoto(JP)**

(74) Representative: **Billington, Lawrence Emlyn et al**
**HASELTINE LAKE & CO Hazlitt House 28 Southampton Buildings Chancery Lane London WC2A 1AT(GB)**

## Description

This invention relates to a semiconductor laser device.

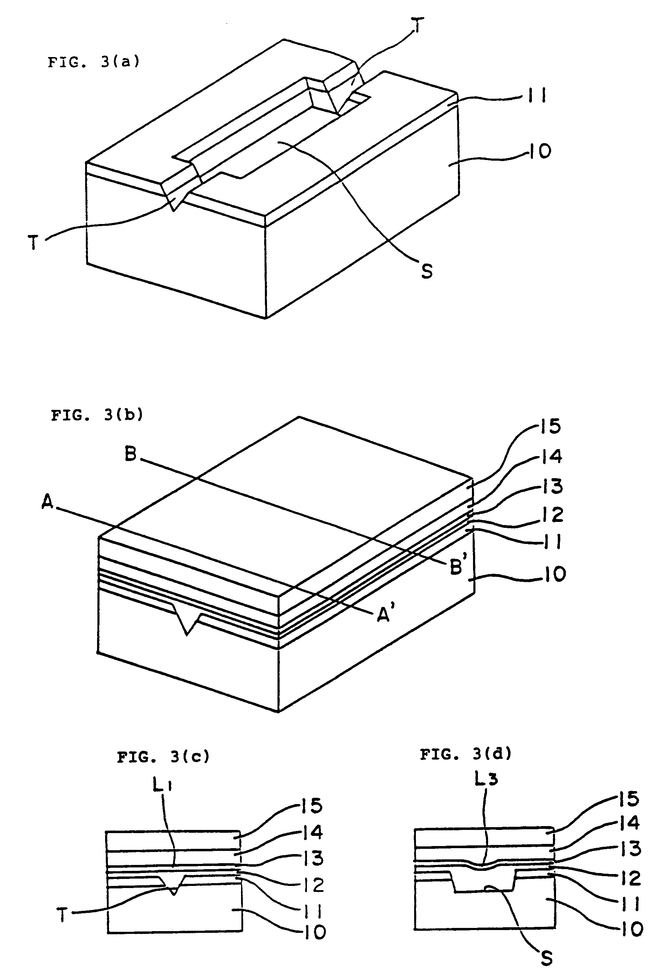

In recent years, a window V-channeled substrate inner-stripe (VSIS) laser having a window structure has been proposed as a semiconductor laser device which can achieve high output power operation (Appl. Phys. Lett., vol. 42, p. 406, 1983 and EP-A-95826). In such a VSIS window laser, the provision of a window region in the vicinity of the facets decreases light absorbance in this vicinity and prevents deterioration of the facets. Such provision also raises the output power at which breakdown of the facets occurs. The VSIS window laser is produced as follows: As shown in Figure **3(a)**, on a p-GaAs substrate **10,** an n-GaAs current blocking layer **11** is grown, followed by an etching treatment to form a trapezoid channel S for the oscillation region and a V-shaped channel T for each of the window regions. Then, as shown in Figure **3(b)**, on the current blocking layer **11** including the channels S and T, a p-GaAlAs cladding layer **12**, a GaAlAs active layer **13**, an n-GaAlAs cladding layer **14**, and an n-GaAs cap layer **15** are successively grown. Figure **3(c)** and **3(d)** show sectional views of lines A-A' and B-B' in Figure **3(b)**. The concaved portion of the active layer **13** shown in section in Figure **3(d)** is the oscillation region $L_3$. The plane portion of active layer **13** shown in section in Figure **3(c)** is the window region $L_1$, which has an optical waveguide therein.

A semiconductor laser device with the above-mentioned structure has an optical waveguide within the window region $L_1$ that has small light absorbance, so that the beam waists are positioned at the facets, thereby allowing for the prevention of deterioration of the facets, and moreover attaining a raise in the output power at which breakdown of the facets occurs. When the width of the optical waveguide in the window region $L_1$ is selected to be about **4** $\mu$m, gain in the high-order transverse mode is suppressed and oscillation in the fundamental transverse mode is achieved.

However, in the semiconductor laser device with the structure described above, there are times when the controllability of the high-order transverse mode is not sufficient, depending upon the conditions of growth and etching. For greater reliability in the control of the high-order transverse mode, the width of channel T of the window region $L_1$ can be narrowed, but if that is done, the cavity length of the window region $L_1$ is correspondingly lengthened, and the differential quantum efficiency decreases due to light absorption to the substrate. Moreover, drastic shortening of the length of the window region $L_1$ is difficult in light of the subsequent separation process of device units from each other.

Furthermore, US-A-4 282 494 discloses a window-structure diffusion type stripe laser using optical obstacle regions in the vicinity of the windows for the suppression of high-order transverse modes.

According to the present invention there is provided a channeled substrate semiconductor laser device comprising a high-order transverse mode absorption region between the oscillation region including a concaved portion of the active layer and each of two window regions including a waveguide in a plane portion of the active layer, said high-order transverse mode absorption region having an optical waveguide the width of which is smaller than that of the optical waveguide in said window region.

A preferred embodiment of the invention described herein makes possible the objects of (1) providing a semiconductor laser device in which gain in the high-order transverse mode is suppressed and stabilized oscillation in the fundamental transverse mode is attained up to a high output power, without the narrowing of the width of the channel in each of the window regions; and (2) providing a semiconductor laser device in which a high-order-mode absorption region having a channel width which is smaller than that of the window region, is disposed between the oscillation region including the concaved portion of the active layer and the window region including the plane portion of the active layer, so that gain in the high-order transverse mode can be suppressed, and in which the length of the high-order-mode absorption region can be reduced sufficiently by the use of a mask pattern, so that the decrease in the differential quantum efficiency can be suppressed.

This invention may be better understood and its numerous advantages will become apparent to those skilled in the art by reference to the accompanying drawings as follows:

Figure **1(a)** is a perspective view showing the unfinished product of a semiconductor laser device according to this invention.

Figure **1(b)** is a plane view of the unfinished product shown in Figure **1(a)**.

Figure **2** is a perspective view showing a semiconductor laser device produced using the unfinished product shown in Figure **1(a)**.

Figure **3(a)** is a perspective view showing the unfinished product of a conventional semiconductor laser device.

Figure **3(b)** is a plane view showing a conventional semiconductor laser device produced using the unfinished product shown in Figure **3(a)**.

Figures **3(c)** and **3(d)**, respectively, are sectional views showing one of the window regions and the oscillation region of the semiconductor laser device shown in Figure **3(b)**.

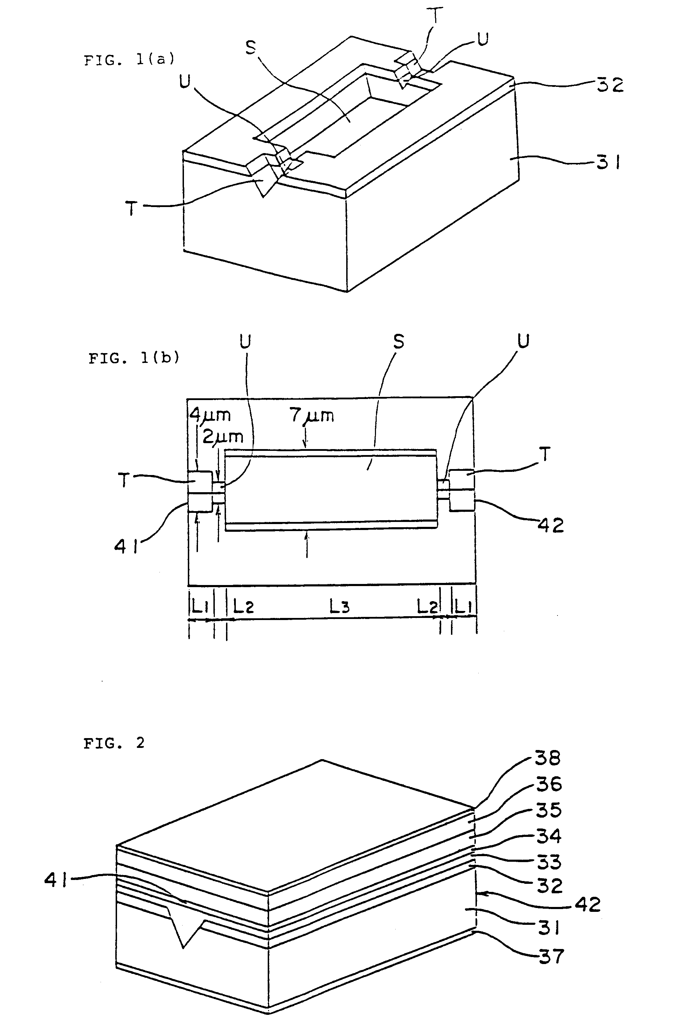

Figures **1(a)**, **1(b)** and **2** show a semiconductor laser device of this invention, which comprises a high-order-mode absorption region $L_2$ between each of the window regions $L_1$, $L_1$ including the plane portion of the active layer **34** and the oscillation region $L_3$ including the concaved portion of the active layer **34**. The said high-order-mode absorption region $L_2$ has an optical waveguide therein, the width of which is smaller than that of the optical waveguide in each of the window regions $L_1$ and $L_1$.

This semiconductor laser device is produced as follows: As shown in Figure **1(a)**, on a p-GaAs substrate **31**, an n-GaAs current blocking layer **32** is grown by liquid phase epitaxy, followed by an etching treatment to form a trapezoid channel S in the center portion thereof, a V-shaped channel T in each of both end portions thereof and a V-shaped channel U between the trapezoid channel S and each of the V-channels T and T. The widths of the channels T, U and S are **4** $\mu$m, **2** $\mu$m and **7** $\mu$m, respectively.

Then, on the current blocking layer **32** including the channels T, U and S, a p-GaAlAs cladding layer **33**, a GaAlAs active layer **34**, an n-GaAlAs cladding layer **35**, and an n-GaAs cap layer **36** are successively grown by liquid phase epitaxy. Ohmic contact layers **37** and **38** are then formed by vacuum deposition on the back face of the p-GaAs substrate **31** and the upper face of the n-GaAs cap layer **36**, respectively, resulting in a semiconductor laser device.

The portion of the active layer **34** corresponding to the V-channel T is the window region $L_1$, the portion of the active layer **34** corresponding to the V-channel U is the high-order-mode absorption region $L_2$, and the other portion of the active layer **34** corresponding to the trapezoid channel S is the oscillation region $L_3$.

A semiconductor laser device with the above-mentioned structure oscillates at a low threshold current level since the portion of the active layer **34** in the oscillation region $L_3$ is curved in the same manner as that shown in Figure **3(d)**. Moreover, in the semiconductor laser device, since an optical waveguide is formed within each of the window regions $L_1$ and $L_1$, the radiation of beams does not arise but the beam waists are positioned near the facets **41** and **42**. Therefore, deterioration of the facets **41** and **42** can be prevented and a raise in the output power at which breakdown of the facets **41** and **42** occurs can be attained. Moreover, the high-order-mode absorption region $L_2$ is positioned between each of the window regions $L_1$, $L_1$ and the oscillation region $L_3$, thereby completely preventing gain in the high-order transverse mode, so that stabilized oscillation can be attained in the fundamental transverse mode up to a high output power.

Although, as a semiconductor material, the GaAlAs system alone is described in the above-mentioned example, other semiconductor crystal materials such as InGaAsP systems can be used.

## Claims

1. A channeled substrate semiconductor laser device comprising a high-order transverse mode absorption region ($L_2$) between the oscillation region ($L_3$) including a concaved portion of the active layer and each of two window regions ($L_1$) including a waveguide in a plane portion of the active layer, said high-order transverse mode absorption region having an optical waveguide the width of which is smaller than that of the optical waveguide in said window region.

## Revendications

1. Un dispositif laser semi-conducteur, à substrat muni de canaux, comportant une région (L2) d'absorption, à mode transversal d'ordre élevé, entre la région (L3) d'oscillation, comprenant une partie rendue concave de la couche active, et chacune de deux régions de fenêtre (L1), comprenant un guide d'onde dans une partie plane de la couche active, ladite région (12) d'absorption à mode transversal d'ordre élevé ayant un guide d'onde optique dont la largeur est inférieure à celle du guide d'onde optique dans ladite région de fenêtre.

## Patentansprüche

1. Kanalsubstrat-Halbleiterlaser mit einem Absorptionsbereich (L2) für Transversalmoden höherer Ordnung zwischen dem Oszillationsbereich (L3) einschließlich eines konkaven Abschnitts der aktiven Schicht und wobei jeder der beiden Fensterbereiche (L1) einen Wellenleiter in einem ebenen Abschnitt der aktiven Schicht aufweist, wobei der Absorptionsbereich für Transversalmoden höherer Ordnung einen optischen Wellenleiter besitzt, dessen Breite geringer als die des optischen Wellenleiters in dem Fensterbereich ist.

FIG. 1(a)

FIG. 1(b)

FIG. 2

FIG. 3(a)

FIG. 3(b)

FIG. 3(c)

FIG. 3(d)